# EUROPÄISCHE PATENTANMELDUNG

(11) **EP 2 019 489 A2**
(43) Veröffentlichungstag der Anmeldung: **28.01.2009**
(21) Anmeldenummer: 08012468.8
(22) Anmeldetag: 10.07.2008
(51) Int. Cl.: H03K 17/96

(54) **Kapazitiver Berührungsschalter**

(30) Priorität: 26.07.2007 DE 102007035455
(71) Anmelder: Diehl AKO Stiftung & Co. KG, 88239 Wangen (DE)
(72) Erfinder: Heimann, Uwe, 88239 Wangen (DE); Prinz, Michael, 88299 Leutkirch (DE)
(74) Vertreter: Diehl Patentabteilung

(57) **Zusammenfassung**

Kapazitiver Berührungsschalter mit einem Berührungsfeld (12) mit einer Oberseite (14) und einer Unterseite (16); einer Leiterplatte (28), die mit einem Abstand unter der Unterseite (16) des Berührungsfeldes (12) angeordnet ist; und einem kapazitiven Sensorelement (20), das an der Unterseite (16) des Berührungsfeldes (12) angeordnet und mit der Leiterplatte (28) elektrisch leitend in Kontakt ist, wobei das kapazitive Sensorelement (20) auf einem Schaltungsträger (18) angeordnet ist, der zur Anpassung an die frei geformte Unterseite (16) des Berührungsfeldes (12) flexibel und dreidimensional verformbar ist.

## Beschreibung

Die Erfindung betrifft einen kapazitiven Berührungsschalter gemäß dem Oberbegriff der Ansprüche 1 und 15.

Aus der DE 10 2005 053 792 A1 ist ein gattungsgemäßer kapazitiver Berührungsschalter bekannt, dessen Sensorelemente durch Federn gebildet sind, die zwischen Leiterplatte und Unterseite des Berührungsfeldes angeordnet sind. Nachteilig an dieser Anordnung ist jedoch, dass der von den Federn zu überbrückende Abstand für alle Sensorelemente im wesentlichen etwa gleich sein muss, um eine einheitliche Auswertung des kapazitiven Signals zu ermöglichen. Ungünstig ist weiterhin, dass die Unterseite des Berührungsfeldes eine ebene Fläche sein muss und somit kein frei geformtes Berührungsfeld mit kapazitiven Berührungsschaltern ausgestattet werden kann.

In Erkenntnis dieser Gegebenheiten liegt vorliegender Erfindung deshalb die Problemstellung zugrunde, einen kapazitiven Berührungsschalter bereitzustellen, der an frei geformten Flächen einsetzbar ist.

Diese Aufgabe wird erfindungsgemäß gelöst durch einen kapazitiven Berührungsschalter mit einem Berührungsfeld mit einer Oberseite und einer Unterseite; einer Leiterplatte, die mit einem Abstand unter der Unterseite des Berührungsfeldes angeordnet ist; und einem kapazitiven Sensorelement, das an der Unterseite des Berührungsfeldes angeordnet und mit der Leiterplatte elektrisch leitend in Kontakt ist, wobei das kapazitive Sensorelement auf einem Schaltungsträger angeordnet ist, der zur Anpassung an die frei geformte Unterseite des Berührungsfeldes flexibel und dreidimensional verformbar ist.

Mit anderen Worten, es wird ein kapazitiver Berührungsschalter bereitgestellt, der ein Berührungsfeld mit einer Oberseite und einer Unterseite aufweist, von der beabstandet eine Leiterplatte angeordnet ist, wobei die Leiterplatte elektrisch leitend mit einem kapazitiven Sensorelement verbunden ist, welches an der Unterseite des Berührungsfeldes angeordnet ist. Besonders vorteilhaft ist, dass ein kapazitives Sensorelement auf einem flexiblen und dreidimensional verformbaren Schaltungsträger angeordnet ist, der infolge seiner Flexibilität und Verformbarkeit an die frei geformte Unterseite des Berührungsfeldes anpassbar ist und dadurch einen einheitlichen Abstand zwischen Sensorelement und Oberseite des Berührungsfeldes gewährleistet. Dieser einheitliche Abstand ermöglicht eine besonders einfache Auswertung des kapazitiven Signals.

Um die Lage eines kapazitiven Berührungsschalters auf dem Berührungsfeld deutlicher hervorzuheben, könnte die Stelle des Berührungsfeldes, an der sich der Schalter befindet, beispielsweise durch eine ansteigende, abgerundete Erhebung gekennzeichnet sein. Die Erhebung ist an der Unterseite des Berührfeldes nicht mit Material ausgefüllt, sondern unter Beibehaltung der Materialstärke des Berührungsfeldes der Erhebung angeglichen. Vorteilhaft ist es, in den Hohlraum der Kuppel, also an die frei geformte Unterseite des Berührungsfeldes einen Schaltungsträger mit kapazitivem Sensorelement anzuordnen, wobei sich der Schaltungsträger an der Unterseite des Berührungsfeldes in den kuppelförmigen Hohlraum einpasst.

Die genannte Aufgabe löst ebenfalls ein Kapazitiver Berührungsschalter mit einem Berührungsfeld mit einer Oberseite und einer Unterseite; einer Leiterplatte, die mit einem Abstand unter der Unseite des Berührungsfeldes angeordnet ist; und einem kapazitiven Sensorelement, das mit der Leiterplatte elektrisch leitend in Kontakt ist, wobei das kapazitive Sensorelement auf einem Schaltungsträger angeordnet ist, der zur Anpassung an die frei geformte Unterseite des Berührungsfeldes flexibel und dreidimensional verformbar ist, wobei der Schaltungsträger zumindest teilweise in das Berührungsfeld integriert ist.

Bei einem derartigen kapazitiven Berührungsschalter ist der flexible und dreidimensional verformbare Schaltungsträger, auf dem das kapazitive Sensorelement angeordnet ist, in ein frei formbares Berührungsfeld zumindest teilweise integriert, beispielsweise durch Umspritzen. Auf diese Weise können beispielsweise Erhebungen des Berührungsfeldes realisiert werden und aufgrund der Verformbarkeit des Schaltungsträgers ein gleichmäßiger Abstand zwischen Schaltungsträger und Berührungsfeldoberfläche gewährleistet werden, wodurch eine einheitliche Schaltbarkeit der Sensorelemente erzielt wird.

Vorteilhafte Ausgestaltungen und Weiterbildungen dieser erfindungsgemäßen Lösung ergeben sich in übertragbarer weise aus den folgenden abhängigen Ansprüchen zur ersten erfindungsgemäßen Lösung.

In einer vorteilhaften Weiterbildung ist das kapazitive Sensorelement in den Schaltungsträger integriert. Hierdurch wird eine Schutzfunktion für das Sensorelement erzielt und die Störanfälligkeit des Berührungsschalters reduziert.

In einer bevorzugten Alternative ist das kapazitive Sensorelement auf der Vorder-und/oder der Rückseite des Schaltungsträgers angeordnet. Dadurch wird eine vorteilhafte Lösung bereitgestellt, mit der je nach verfügbarem Platz im Berührungsschalter den Anpasserfordernissen optimal Rechnung getragen werden kann.

In einer weiteren Ausführungsform weist der Schaltungsträger Entstör- und/oder Abschirm- und/oder Schutzelemente auf. Mit diesen Mitteln wird sichergestellt, dass die Sensorelemente von solchen sich in der Umgebung befindlichen elektronischen Bauteilen bezüglich negativer und ungewollter Wechselwirkungen abgeschirmt sind.

Vorteilhafterweise ist der Schaltungsträger streifenförmig, rund oder oval ausgebildet. Hierdurch lässt sich der Schaltungsträger besonders gut an den zur Verfügung stehenden Raum anpassen und darüber hinaus Wünsche an die Veränderung des Layouts des Berührungsschalters umsetzen.

Zweckmäßigerweise weist der Schaltungsträger Einschnitte und/oder Ausschnitte zur Verbesserung der Anpassbarkeit auf. Durch derartige Aussparungen lässt sich die Anpassbarkeit des Schaltungsträgers weiter verbessern.

In einer weiteren Ausgestaltung ist das kapazitive Sensorelement rechteckig, quadratisch, rund, oval oder segmentförmig ausgebildet. Hierdurch ist es möglich, verschiedene Tastenformen bei gleichzeitig hoher Sensorleistung abzubilden.

In einer weiteren Ausgestaltung ist der an die frei geformte Unterseite des Berührungsfeldes angepasste Schaltungsträger dauerhaft mit der Unterseite des Berührungsfeldes verbunden, insbesondere durch Verkleben oder Nieten. Durch diese Maßnahme wird erreicht, dass der kapazitive Berührungsschalter störungsfrei arbeitet, da Schaltungsträger und Sensor nicht lösbar mit dem Berührungsfeld verbunden sind.

Vorteilhafterweise ist der an die frei geformte Unterseite des Berührungsfeldes angepasste Schaltungsträger lösbar mit der Unterseite des Berührungsfeldes verbunden, insbesondere durch Verschrauben, Verstemmen, Druckfedern, Spannklammern oder Hafthaken. Hierdurch wird ermöglicht, dass im Störungsfall Schaltungsträger austauschbar sind.

In einer besonders vorteilhaften Weiterbildung laufen die Zuleitungen zum kapazitiven Sensorelement über einen Kabelschwanz des Schaltungsträgers. Als Kabelschwanz wird der sensorfreie Bereich des flexiblen Schaltungsträgers verstanden, über den Zuleitungen laufen. Der Kabelschwanz kann schmaler ausgebildet sein als der Schaltungsträger und an seinem Ende mit einem handelsüblichen Stecker versehen werden, um den Schaltungsträger mit der Leiterplatte zu kontaktieren. Derartige Zuleitungen sind besonders kostengünstig, da diese bereits bei der Herstellung des Schaltungsträgers mit auf diesen aufgebracht werden können und kein zusätzliches Verkabeln erforderlich ist.

In einer vorteilhaften Weiterbildung ist der Schaltungsträger direkt an der Unterseite des Berührungsfeldes angeordnet. Da keine weiteren Bauteile erforderlich sind, handelt es sich hierbei um eine besonders kostengünstige Ausgestaltung.

In einer bevorzugten Alternative ist der Schaltungsträger zumindest teilweise gekapselt, wobei die Kapselung des Schaltungsträgers an die frei geformte Unterseite des Berührungsfeldes angepasst und an der Unterseite des Berührungsfeldes angeordnet ist. Der Schaltungsträger wird also wenigstens teilweise, beispielsweise durch Umspritzen gekapselt und hierbei die Kapselung so ausgeführt, dass die Oberfläche der Kapselung des Schaltungsträgers der frei geformten Unterseite des Berührungsfeldes angepasst ist. Auf diese Weise wird der Schaltungsträger besonders montagefreundlich vorbereitet und die Kapselung schließlich an der Unterseite des Berührungsfeldes angeordnet.

In einer weiteren Ausführungsform sind mehrere kapazitive Sensorelemente auf einem Schaltungsträger angeordnet. Dabei ist es besonders vorteilhaft, dass die mehreren kapazitiven Sensorelemente voneinander elektrisch isoliert sind. Auf diese Weise lassen sich kapazitive Berührungsschalter mit mehreren Schaltstellen herstellen.

Mehrere Ausführungsbeispiele werden anhand der Zeichnung und anhand der nachstehenden Beschreibung näher erläutert. Es zeigen:
- Fig. 1: Einen schematisch dargestellten kapazitiven Berührungsschalter im unmontierten Zustand,
- Fig. 2: Rund ausgebildete Schaltungsträger mit unterschiedlich geformten Sensorelementen,
- Fig. 3: Streifenförmig ausgebildete Schaltungsträger mit unterschiedlich geformten Sensorelementen, und
- Fig. 4: Einen ringförmig ausgestalteten Schaltungsträger.

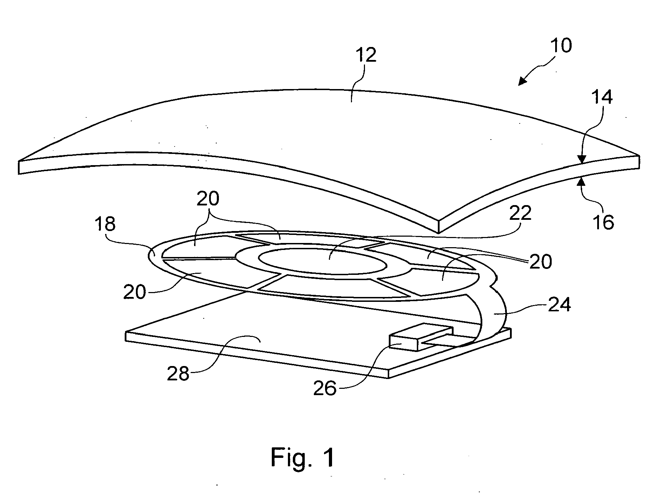

Figur 1 zeigt einen kapazitiven Berührungsschalter 10 im unmontierten Zustand. Hierbei ist das Berührungsfeld 12 im gezeigten Ausschnitt gewölbt ausgestaltet, wobei die Wölbung sowohl auf der Oberseite 14, als auch auf der Unterseite 16 wiedergegeben ist. Die Wölbung ist ein Beispiel für eine frei geformte Fläche. Der Schaltungsträger 18 trägt kapazitive Sensorelemente 20 und weist im Zentrum des kreisförmigen Schaltungsträgers 18 einen runden Ausschnitt 22 zur Steigerung der Anpassbarkeit des Schaltungsträgers 18 an die frei geformte Fläche auf. Die Zuleitungen 30 zu den elektrisch voneinander isolierten kapazitiven Sensorelementen 20 laufen über einen Kabelschwanz 24, an dem ein Stecker 26 zum Anschließen des Schaltungsträgers 18 an eine Leiterplatte 28 angebracht ist.

Bei der Montage des Schaltungsträgers 18 an die Unterseite 16 des Berührungsfeldes 12 verformt sich der Schaltungsträger 18 und passt sich flexibel an die dreidimensionale Form der Unterseite 16 an. Hierdurch wird garantiert, dass die kapazitiven Sensorelemente 20 mit einem einheitlichen Abstand zur Oberseite 14 des Berührungsfeldes 12 angeordnet sind.

Im vorliegenden Beispiel sind sechs segmentartig ausgeformte kapazitive Sensorelemente 20 auf dem Schaltungsträger 18 angeordnet. Je nachdem wie viele unabhängige Berührungsschalter 10 erforderlich sind, können mehr oder weniger kapazitive Sensorelemente 20 auf dem Schaltungsträger 18 angeordnet sein.

Die kapazitiven Sensorelemente 20 können entweder auf der Vorder- oder auf der Rückseite des Schaltungsträgers 18, aber auch sowohl auf der Vorder- als auch auf der Rückseite des Schaltungsträgers 18 angeordnet sein. Hierdurch kann auf fertigungsprozesstechnisch bedingte Anforderungen reagiert werden, wie zum Beispiel die Vermeidung von Beschädigungen der Sensorelemente 20 durch Kleber oder durch Druckstempel. Darüber hinaus ist eine flexiblere Einsetzbarkeit des Schaltungsträgers 18 möglich. So kann beispielsweise auf sehr reduzierte Platzverhältnisse unter dem Berührungsfeld 12 reagiert werden und der Schaltungsträger 18 mit einem gestreckten Kabelschwanz 24 im Gegensatz zu dem in Figur 1 gezeigten umgebogenen Kabelschwanz 24 montiert werden.

In einer anderen Ausführungsform können die kapazitiven Sensorelemente 20 in den Schaltungsträger 18 integriert sein, beispielsweise durch Beschichten der Sensorelemente 20 mit dem Material des Schaltungsträgers 18. Hierdurch werden die kapazitiven Sensorelemente 20 gegenüber mechanischen Einwirkungen, wie Staub oder anderen kleinteiligen Partikel vor Schädigung geschützt.

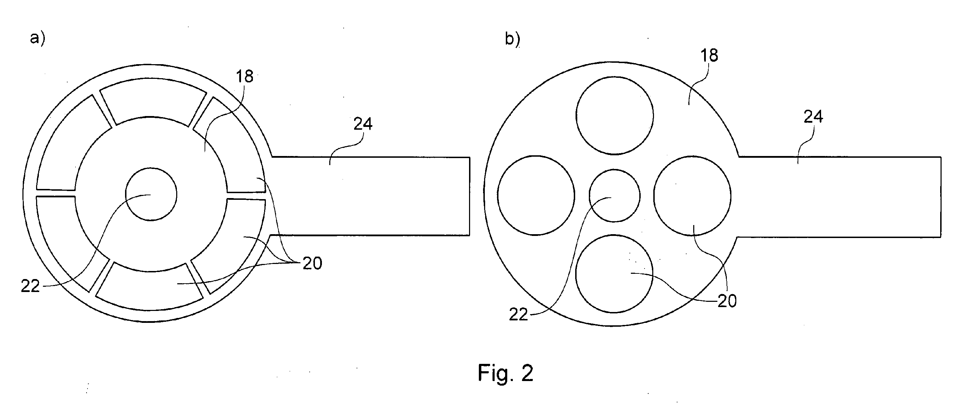

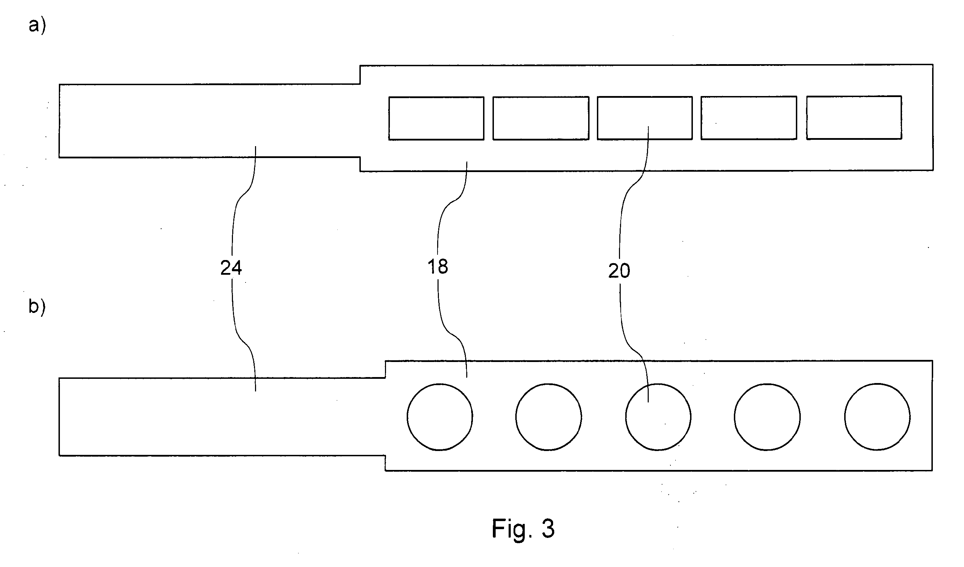

Figur 2 zeigt zwei runde Schaltungsträger 18 mit einem zentralen Ausschnitt 22. Grundsätzlich ist für den Schaltungsträger 18 jede beliebige Form möglich. Gleiches gilt für die kapazitiven Sensorelemente 20. Beispielhaft ist in Figur 2a ein Schaltungsträger 18 mit segmentartig ausgestalteten Sensorelementen 20 und in Figur 2b ein Schaltungsträger 18 mit runden Sensorelementen 20 dargestellt. Figur 3 zeigt streifenförmig ausgebildete Schaltungsträger 18 mit rechteckigen (Figur 3a) und runden Sensorelementen (Figur 3b).

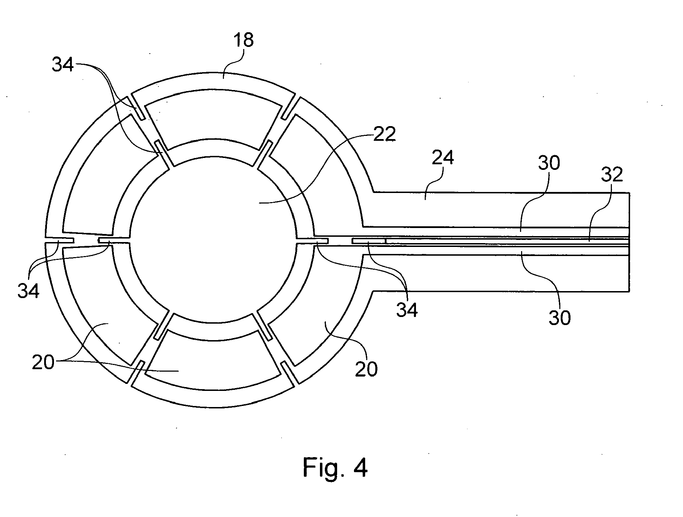

In Figur 4 ist ein ringförmiger Schaltungsträger 18 mit einem großen zentralen Ausschnitt 22 dargestellt, auf dem segmentförmige Sensorelemente 20 angeordnet sind. Weiter sind exemplarisch zu zwei der sechs abgebildeten Sensorelemente 20 über den Kabelschwanz 24 laufende Zuleitungen 30 dargestellt. Zwischen den Zuleitungen 30 ist beispielhaft ein Entstörelement 32 angedeutet. Das Ende des Kabelschwanzes 24 ist mit einem Stecker versehbar und ist damit einfach an eine Leiterplatte 28 anschließbar. Ein Stecker ist jedoch nicht zwingend erforderlich. So kann beispielsweise durch Klemmkontaktierung der Schaltungsträger 18 direkt mit der Leiterplatte 28 elektrisch verbunden werden. Zur Verbesserung der Anpassbarkeit des Schaltungsträgers 18 an eine frei geformte Unterseite 16 eines Berührungsfeldes 12, sind neben dem Ausschnitt 22 mehrere Einschnitte 34 abgebildet.

Die Schaltungsträger 18 können auf unterschiedliche Weise an der Unterseite 16 des Berührungsfeldes 12 befestigt werden. Zum einen kann der Schaltungsträger 18 unmittelbar und direkt an der Unterseite 16 oder zum anderen in gekapselter Form angebracht werden, wobei die Befestigung an der Unterseite 16 dauerhaft oder lösbar sein kann.

Als gekapselte Form kann eine Vollkapselung mit vollständig umschlossener Vorder- und Rückseite des Schaltungsträgers 18 oder eine Teilkapselung eingesetzt werden. Bei einer Teilkapselung ist beispielsweise nur die Rückseite des Schaltungsträgers 18 umschlossen bzw. eingekapselt, wogegen die Vorderseite ungekapselt verbleibt. Auch eine umgekehrte und fragmentartige Anbringung der Kapselung am Schaltungsträger 18 ist möglich.

Unabhängig von Voll- oder Teilkapselung ist die Kapselung jedoch so ausgeführt, dass diese an die frei geformte Unterseite 16 des Berührungsfeldes 12 angepasst ist, oder in anderen Worten, ein Gegenstück zur frei geformten Unterseite 16 bildet. In entsprechender Weise ist der Schaltungsträger 18 in der Kapselung an die frei geformte Unterseite16 des Berührungsfeldes 12 angepasst.

Durch die Verwendung einer Kapselung ist eine einfachere Montage möglich, da der Schaltungsträger 18 ohne besondere Vorsichtsmaßnahmen montierbar ist und eine Zerstörung des Schaltungsträgers 18 ausgeschlossen ist.

In einer alternativen Ausführungsform ist der Schaltungsträger 18 in das Berührungsfeld 12 integriert. Hierfür wird der Schaltungsträger 18 der gewünschten freien Form des Berührungsfeldes 12 folgend beim Gießen oder Spritzen des Berührungsfeldes 12 entsprechend angepasst angeordnet und der Schaltungsträger 18 vom Material des Berührungsfeldes 12 umschlossen. Bei dieser Ausführung ragt lediglich der Kabelschwanz 24 beispielsweise aus der Unterseite 16 des Berührungsfeldes 12 heraus.

## Patentansprüche

1. Kapazitiver Berührungsschalter mit einem Berührungsfeld (12) mit einer Oberseite (14) und einer Unterseite (16); einer Leiterplatte (28), die mit einem Abstand unter der Unterseite (16) des Berührungsfeldes (12) angeordnet ist; und einem kapazitiven Sensorelement (20), das an der Unterseite (16) des Berührungsfeldes (12) angeordnet und mit der Leiterplatte (28) elektrisch leitend in Kontakt ist,
**dadurch gekennzeichnet,**
**dass** das kapazitive Sensorelement (20) auf einem Schaltungsträger (18) angeordnet ist, der zur Anpassung an die frei geformte Unterseite (16) des Berührungsfeldes (12) flexibel und dreidimensional verformbar ist.

2. Kapazitiver Berührungsschalter nach Anspruch 1,
**dadurch gekennzeichnet,**
**dass** das kapazitive Sensorelement (20) in den Schaltungsträger (18) integriert ist.

3. Kapazitiver Berührungsschalter nach einem der vorhergehenden Ansprüche,
**dadurch gekennzeichnet,**
**dass** das kapazitive Sensorelement (20) auf der Vorder- und/oder der Rückseite des Schaltungsträgers (18) angeordnet ist.

4. Kapazitiver Berührungsschalter nach einem der vorhergehenden Ansprüche,
**dadurch gekennzeichnet,**
**dass** der Schaltungsträger (18) Entstör- und/oder Abschirm- und/oder Schutzelemente aufweist.

5. Kapazitiver Berührungsschalter nach einem der vorhergehenden Ansprüche,
**dadurch gekennzeichnet,**
**dass** der Schaltungsträger (18) streifenförmig, rund oder oval ausgebildet ist.

6. Kapazitiver Berührungsschalter nach einem der vorhergehenden Ansprüche,
**dadurch gekennzeichnet,**
**dass** der Schaltungsträger (18) Einschnitte (34) und/oder Ausschnitte (22) zur Verbesserung der Anpassbarkeit aufweist.

7. Kapazitiver Berührungsschalter nach einem der vorhergehenden Ansprüche,
**dadurch gekennzeichnet,**
**dass** das kapazitive Sensorelement (20) rechteckig, quadratisch, rund, oval oder segmentförmig ausgebildet ist.

8. Kapazitiver Berührungsschalter nach einem der vorhergehenden Ansprüche,
**dadurch gekennzeichnet,**
**dass** der an die frei geformte Unterseite (16) des Berührungsfeldes (12) angepasste Schaltungsträger (18) dauerhaft mit der Unterseite (16) des Berührungsfeldes (12) verbunden ist, insbesondere durch Verkleben oder Nieten.

9. Kapazitiver Berührungsschalter nach einem der Ansprüche 1 bis 7,
**dadurch gekennzeichnet,**
**dass** der an die frei geformte Unterseite (16) des Berührungsfeldes (12) angepasste Schaltungsträger (18) lösbar mit der Unterseite (16) des Berührungsfeldes (12) verbunden ist, insbesondere durch Verstemmen, Verschrauben, Druckfedern, Spannklammern oder Rasthaken.

10. Kapazitiver Berührungsschalter nach einem der vorhergehenden Ansprüche,
**dadurch gekennzeichnet,**
**dass** die Zuleitungen (30) zum kapazitiven Sensorelement (20) über einen Kabelschwanz (24) des Schaltungsträgers (18) laufen.

11. Kapazitiver Berührungsschalter nach einem der vorhergehenden Ansprüche,
**dadurch gekennzeichnet,**
**dass** der Schaltungsträger (18) direkt an der Unterseite (16) des Berührungsfeldes (12) angeordnet ist.

12. Kapazitiver Berührungsschalter nach einem der Ansprüche 1 bis 10,
**dadurch gekennzeichnet,**
**dass** der Schaltungsträger (18) zumindest teilweise gekapselt ist, wobei die Kapselung des Schaltungsträgers (18) an die frei geformte Unterseite (16) des Berührungsfeldes (12) angepasst und an der Unterseite (16) des Berührungsfeldes (12) angeordnet ist.

13. Kapazitiver Berührungsschalter nach einem der vorhergehenden Ansprüche,
**dadurch gekennzeichnet,**
**dass** mehrere kapazitive Sensorelemente (20) auf einem Schaltungsträger (18) angeordnet sind.

14. Kapazitiver Berührungsschalter nach Anspruch 13,
**dadurch gekennzeichnet,**
**dass** die mehreren kapazitiven Sensorelemente (20) gegeneinander elektrisch isolierst sind.

15. Kapazitiver Berührungsschalter mit einem Berührungsfeld (12) mit einer Oberseite (14) und einer Unterseite (16); einer Leiterplatte (28), die mit einem Abstand unter der Unseite (16) des Berührungsfeldes (12) angeordnet ist; und einem kapazitiven Sensorelement (20), das mit der Leiterplatte (28) elektrisch leitend in Kontakt ist,
**dadurch gekennzeichnet,**
**dass** das kapazitive Sensorelement (20) auf einem Schaltungsträger (18) angeordnet ist, der zur Anpassung an die frei geformte Unterseite (16) des Berührungsfeldes (12) flexibel und dreidimensional verformbar ist, wobei der Schaltungsträger (18) zumindest teilweise in das Berührungsfeld (18) integriert ist.
